# EUROPÄISCHE PATENTSCHRIFT

(11) **EP 0 557 480 B1**
(45) Veröffentlichungstag und Bekanntmachung des Hinweises auf die Patenterteilung: **17.05.1995**
(21) Anmeldenummer: 92918008.1
(22) Anmeldetag: 26.08.1992
(51) Int. Cl.: C30B 15/10

(54) **MEHRTEILIGER STÜTZTIEGEL**
MULTIPART SUPPORTING CRUCIBLE
CREUSET DE SUPPORT EN PLUSIEURS PARTIES

(30) Priorität: 12.09.1991 DE 4130253
(43) Veröffentlichungstag der Anmeldung: 01.09.1993
(73) Patentinhaber: Ringsdorff-Werke GmbH, 53170 Bonn (DE)
(72) Erfinder: WEGMETH, Julius, D-5307 Wachtberg (DE); SCHMIDT, Bernd, D-5300 Bonn 2 (DE)
(86) Internationale Anmeldenummer: EP9201956
(87) Internationale Veröffentlichungsnummer: WO9305205

(56) Entgegenhaltungen:
- DE-A- 3 743 952
- DE-A- 4 007 053
- PATENT ABSTRACTS OF JAPAN, vol. 16, no. 1 (C-899), 7. Januar 1992; & JP-A-32 28 892
- PATENT ABSTRACTS OF JAPAN, vol. 7, no. 195 (C-183)(1340), 25. August 1983; & JP-A-58 95 693
- PATENT ABSTRACTS OF JAPAN, vol. 7, no. 14 (C-146)(1159), 20. Januar 1983; & JP-A-57 170 892

## Beschreibung

Die Erfindung betrifft einen Stütztiegel aus mindestens zwei Segmenten, bei dem die Segmente durch im Seitenwandbereich des Tiegels bis zum Tiegelboden im wesentlichen senkrecht verlaufende und auch den Tiegelboden durchsetzende Fugen getrennt sind.

Derartige Tiegel dienen zur Aufnahme und Stützung von einteiligen Tiegeln, die bei Temperaturen oberhalb ihrer Deformationsgrenze betrieben werden und Schmelzen von Substanzen enthalten. Sie müssen Dehnungen und Schrumpfungen des gestützten Tiegels ausgleichen können und bestehen deshalb aus mindestens Zwei durch senkrechte Teilung entstandenen Segmenten. Sie müssen zusätzlich die Funktion eines Suszeptors zur Übertragung von Wärmeenergie auf den gestützten Tiegel erfüllen. Werkstoffseitig werden an sie hohe Anforderungen gestellt: Sie müssen bei Temperaturen oberhalb der in der Anlage herrschenden Schmelz- oder Reaktionstemperatur formstabil sein und dürfen mit dem Werkstoff des jeweils unterstützten Tiegels keine Schmelzen bilden. Im Idealfall sollen sie mit dem Material des unterstützten Tiegels chemisch nicht reagieren und keine den Verfahrensablauf störenden Verunreinigungen abgeben.

Hauptanwendungsgebiet der Stütztiegel ist die Herstellung von Kristallen aus einer Schmelze, insbesondere von Einkristallen aus z.B. Germanium, Silicium oder binären Verbindungen für die Halbleiterindustrie nach dem Tiegelziehverfahren. Die Erfindung soll im folgenden anhand des am häufigsten angewandten Verfahrens, nämlich des Czochralski-Verfahrens, beispielhaft beschrieben werden. Auf eine genaue Beschreibung dieses Verfahrens oder anderer Tiegelziehverfahren wird an dieser Stelle verzichtet und auf die einschlägige Literatur, z.B. Winnacker/Küchler, Chem. Technologie, 4. Auflage, Band 3, Seiten 424 bis 427 und 452 bis 460, Carl Hanser Verlag München/Wien 1983 sowie auf Ullmann, Encyclopedia of Industrial Chemistry, Fifth Edition, Vol. A8, page 121 ff., VCH Verlagsgesellschaft Weinheim 1987 und die dort zitierte Literatur verwiesen. Die Verwendung der erfindungsgemäßen Tiegel ist jedoch nicht auf die vorgenannten Verfahren beschränkt. Sie gilt für alle Verfahren, bei denen von außen indirekt, insbesondere durch Strahlung beheizte Tiegel durch einen Stütztiegel umfangen werden.

Bei der Variante des Tiegelziehverfahrens befindet sich in einem ersten, im Inneren der Apparatur angeordneten Tiegel die Schmelze eines Elements wie Silicium aus der mittels eines in die Schmelze eintauchenden, meist stabförmigen Einkristalls als Impf- oder Mutterkristall unter Drehen ein Einkristallstab gezogen wird. Dieser erste Tiegel besteht häufig aus Quarz und besonders beim Ziehen von Siliciumeinkristallen ist die Temperatur so hoch, daß der Quarztiegel plastisch wird und einer äußeren, formstabilen Stütze bedarf. Als Stütze werden bevorzugt Graphittiegel verwendet, die mehrteilig ausgeführt sein müssen, da sich der Quarztiegel bei Temperaturänderungen zusammenzieht, bzw. ausdehnt und der Stütztiegel diese Bewegungen mitmachen muß. Besonders beim Abkühlen kommt es zu einer Ausdehnung des Quarztiegels, die kristisch wäre. Die innere Tiegelanordnung wird durch Heizvorrichtungen auf die gewünschte Schmelztemperatur gebracht und auf ihr gehalten. Vorzugsweise bedient man sich hierbei der Strahlungsheizung. Eine die Tiegel im Abstand umgebende Anordnung eines oder mehrerer Heizelemente wird durch direkten Stromdurchgang oder induktiv erhitzt und überträgt im wesentlichen durch Strahlung Wärme auf den auch als Suszeptor wirkenden Stütztiegel, über den die Wärme im wesentlichen durch Wärmeleitung auf den gestützten Tiegel und die Schmelze übertragen wird.

Hierbei ergeben sich Probleme für das Ziehen der Kristalle, an die höchste Anforderungen an Reinheit und Fehlerfreiheit des Kristallaufbaus gestellt werden. Ein Teil der Strahlung trifft durch die die Segmente des Stütztiegels trennenden Fugen den die Schmelze enthaltenden Tiegel direkt und bewirkt an diesen direkt bestrahlten Zonen gegenüber den von den Suszeptorsegmenten indirekt und damit gleichmäßig beheizten Zonen des Tiegels Temperaturinhomogenitäten und damit Fehlströmungen und Turbulenzen in der Schmelze, die zu Ungleichmäßigkeiten beim Kristallwachstum und zu einer unerwünschten Aufnahme von Verunreinigungen wie Sauerstoff führen. Ein anderes Problem ergibt sich, wenn, wie im in der Praxis häufigsten Fall der unterstützte Tiegel aus Quarzglas und der Stütztiegel aus Kohlenstoff, speziell aus Graphit ist. An den Zonen, an denen die Trennfugenkanten der Segmente die Quarztiegel berühren, finden unter der direkten Einwirkung der Wärmestrahlung auf den Quarztiegel verstärkt Reaktionen zwischen dem Kohlenstoff des Stütztiegels und dem Quarz unter Bildung von Kohlenmonoxid und Siliciummonoxid statt. Durch diese Vorgänge werden der Quarztiegel und der Stütztiegel entlang den Trennfugen geschwächt und ihre Lebensdauer wird verkürzt, was den Aufwand für das Verfahren erheblich erhöht.

Durch die deutsche Patentschrift Nr. 40 07 053 wird ein Graphitstütztiegel für das Ziehen von Siliciumeinkristallen aus Quarztiegeln beschrieben, der auf seiner Innenfläche, dem oberen Rand und den Berührungsflächen der Segmente mit einer Schutzschicht aus in einem verbindenden Gerüst aus Kohlenstoff angeordneten gereckten Endloskohlenstoffasern, die nach einer möglichen Ausführungsform als Füllstoff zusätzlich Kohlenstoff- oder Graphitpulver enthalten kann, ausgerüstet ist. Zweck dieser Erfindung war es, einen Stütztiegel für Quarztiegel zu schaffen, der gegenüber dem Angriff von Silicium, Siliciummonoxid und Siliciumdioxid beständig ist. Die beschriebene Lösung verringert zwar das allgemeine Problem der Reaktion der sich berührenden Werkstoffe und von aus dieser Reaktion entstandenen Produkten mit dem Graphittiegel, berührt aber nicht die speziellen Probleme, die sich aus der direkten Wärmebestrahlung der Quarztiegelwand entlang den Trennfugen der Stütztiegelsegmente ergeben und kann sie folglich auch nicht lösen.

Die Aufgabe der Erfindung war es deshalb, einen aus Segmenten bestehenden Stütztiegel für eine Schmelze enthaltende gestützte Tiegel zu schaffen, der so geformt ist, daß der gestützte Tiegel, der von der den Stütztiegel umgebenden Heizung ausgehenden Strahlung im Bereich der zwischen den Segmenten des Stütztiegels im Mantelbereich befindlichen Trennfugen nicht mehr ausgesetzt ist.

Die Aufgabe wird durch die kennzeichnenden Teile der Patentansprüche 1 und 2 gelöst. Die Unteransprüche 3 bis 8 enthalten zweckmäßige Ausgestaltungen der erfindungsgemäßen Tiegel, Anspruch 9 betrifft eine bevorzugte Anwendung, Anspruch 10 ein Verfahren zur Herstellung eines derartigen Tiegels.

Durch die überlappende Anordnung der sich in Umfangsrichtung des Stütztiegels gegenüberliegenden Begrenzungsflächen der Segmente trifft die von der die Tiegelanordnung umgebenden Heizung ausgehende Wärmestrahlung im gesamten Mantelbereich nicht mehr auf die Wand des die Schmelze enthaltenden Tiegels. Die früher in den Bereichen der zwischen den Segmenten des Stütztiegels liegenden Trennfugen aufgetretenen schädlichen Wirkungen der Wärmeeinstrahlung sind damit beseitigt.

Tiegelsegmente, aus denen erfindungsgemäße Stütztiegel zusammengesetzt werden können, können durch entsprechende, an sich bekannte keramische Formgebungs- und Herstellungsverfahren und, falls notwendig, anschließendes Bearbeiten von Vorformlingen oder aus Vollmaterial durch spanendes Bearbeiten hergestellt werden.

Beim zweiten Verfahren zur Herstellung erfindungsgemäßer Stütztiegel werden zunächst ganze Tiegel hergestellt und diese anschließend durch Schneiden oder andere spanabhebende Bearbeitungsschritte in mindestens zwei Segmente vertikal wie folgt durchtrennt: An den Stellen, an denen der Tiegelmantel getrennt werden soll, werden parallel zur Mittelachse des Tiegels aber in einem von 90° abweichenden Winkel zur Manteloberfläche verlaufende Schnitte an der Manteloberfläche angesetzt und bogenförmig, auch den Tiegelboden durchsetzend, bis zur Mittelachse geführt. Die durch diese Schnitte entstandenen Stütztiegelsegmente haben an den die Tiegelwand durchsetzenden Trennfugen komplementäre Flächen, die sich überlappen und den gestützten Tiegel vor der einfallenden Strahlung abschirmen. Der Grad der Überlappung wird durch den Winkel, bezogen auf die Oberfläche des Tiegelmantels bestimmt, mit dem der Schnitt geführt wird. Er wird von Fall zu Fall den jeweiligen Gegebenheiten entsprechend festgelegt. Am Tiegelboden entstehen bei dieser Verfahrensweise nicht überlappende Begrenzungsflächen zwischen den Tiegelsegmenten an den Fugen. Dies ist jedoch nicht nachteilig, da diese Fugen vom am Boden des Stütztiegels angeordneten und die Segmente des Stütztiegels in ihren Positionen haltenden Halte- und Unterstützungsteil abgedeckt werden können. Wo eine solche Abdeckung nicht oder nur teilweise möglich ist, ist die negative Wirkung der Wärmestrahlung auf den gestützten Tiegel wegen des schrägen Einfallswinkels und des damit verbundenen geringen Absorptionsgrades der von den im wesentlichen parallel zur Tiegelwand angeordneten Heizelementen stammenden Strahlung gering. Nach diesem Verfahren kann in vorteilhafter Weise jede Trennfuge in einem Bearbeitungsschritt mit einem einfachen Schneidwerkzeug, z.B. einer Bandsäge, in hoher Präzision hergestellt werden.

Ein Stütztiegel kann aus zwei, drei oder mehr Segmenten bestehen. Die bevorzugte Ausführungsform besteht jedoch aus drei Segmenten gleicher Gestalt. Ein derartiger Tiegel läßt sich rationell herstellen, leicht handhaben und er gleicht die Ausdehnungen und Schrumpfungen des gestützten Tiegels hinreichend gut aus.

Erfindungsgemäße Stütztiegel bestehen bevorzugt aus Kohlenstoff. Wegen seiner guten Bearbeitbarkeit, Fähigkeit zur Absorption von Wärmestrahlen, guten Wärmeleitfähigkeit und chemischen Inaktivität empfiehlt sich in den meisten Fällen die Verwendung von Elektrographit. Als weitere Werkstoffe aus Kohlenstoff kommen kohlenstoffaserverstärkter Kohlenstoff (CFC) und Glaskohlenstoff in Frage.

Für die Herstellung hochreiner Kristalle müssen die Werkstoffe, aus denen die Reaktionsräume der verwendeten Apparaturen bestehen, ebenfalls entsprechend sauber sein. Es ist deshalb zweckmäßig, für die Herstellung von Stütztiegeln vorgesehene Kohlenstoffteile durch eine bei hohen Temperaturen unter Verwendung von halogenhaltigen Gasen durchgeführte Reinigungsbehandlung zu säubern. Das am weitesten verbreitetste Verfahren ist hierfür eine Reinigung des Graphits mit Gasen während der Graphitierungsbehandlung.

Auf eine Beschreibung der Verfahren für die Herstellung der genannten Kohlenstoffwerkstoffe wird verzichtet, da sie Stand der Technik und jedem Fachmann wohl bekannt sind, sowie der einschlägigen Literatur entnommen werden können.

Die Erfindung hat folgende Vorteile:
1. Verringerung des Verschleißes an Stütztiegeln.
2. Verringerung des Verschleißes an gestützten Schmelztiegeln.
3. Verringerung der Gefahr einer Verunreinigung der Schmelze, aus der Kristalle gezogen werden sollen.
4. Vergleichmäßigung der Temperatur der Wand des Schmelztiegels.
5. Rationelle Herstellung von durch erhöhte Ausführungsgenauigkeit verbesserten Stütztiegeln mit Hilfe der bogenförmigen Schnittführung.

Die Punkte 3. und 4. wirken sich direkt positiv auf die Qualität der erzeugten Kristallstäbe aus, die Punkte 1. und 2. vermindern den Aufwand beim Kristallziehen und Punkt 5. gestattet eine Herstellung der verbesserten Stütztiegelausführungen in hoher Genauigkeit.

Im folgenden wird die Erfindung anhand von Figuren beispielhaft beschrieben:
- Fig. 1: gibt einen Vertikalschnitt durch die für die Erfindung wichtigen Elemente einer Kristallziehanlage in schematischer Darstellung wieder.
- Fig. 2 und 2a: zeigen einen Stütztiegel herkömmlicher Art im Vertikalschnitt und in der Draufsicht.
- Fig. 3 und 3a: veranschaulichen einen erfindungsgemäßen Stütztiegel mit bogenförmig vom Tiegelmantel zur Tiegelmitte verlaufenden Fugen im Vertikalschnitt und in der Draufsicht.
- Fig. 4 und 4a: verdeutlichen den Kern der Erfindung durch vergleichende Darstellung des Strahlenganges der Wärmestrahlung bei einem herkömmlichen und einem erfindungsgemäßen Tiegel.

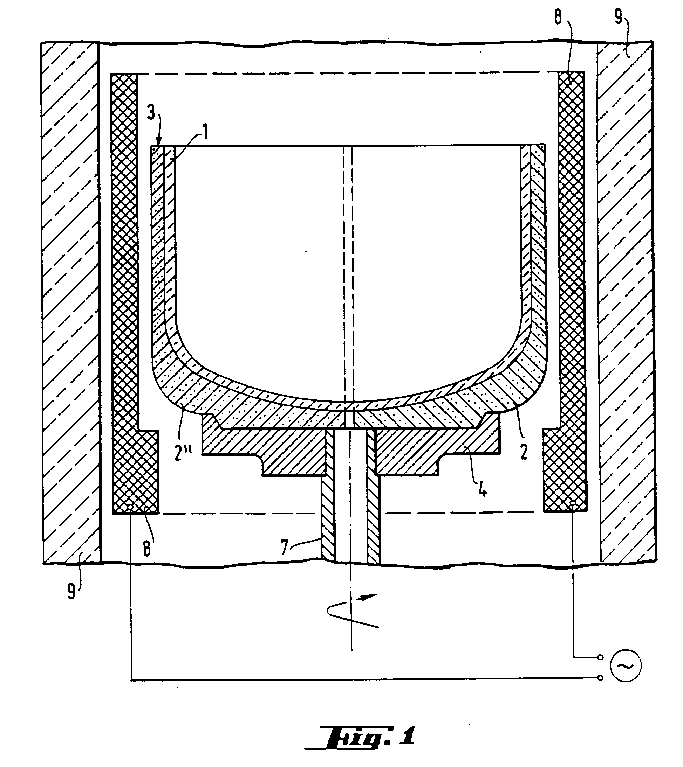

In Fig. 1 wird ein eine nicht dargestellte Schmelze aus Silicium enthaltender Schmelztiegel 1 aus Quarzglas von einem Stütztiegel 3 aus Graphit umschlossen, der aus drei Segmenten 2, 2' und 2'' besteht, wobei im Schnitt nur zwei zu sehen sind. Die Segmente 2, 2', 2'' werden von einem in das Bodenprofil des Stütztiegels 3 eingreifenden Halteteil 4 aus Graphit so in ihrer Lage fixiert, daß sie die während des Verfahrensablaufs stattfindenden Bewegungen des gestützten Quarztiegels ausgleichen können. Die aus Quarztiegel 1, Stütztiegel 3 und Halteteil 4 bestehende Anordnung ruht auf einer Welle 7 über die die vorgenannte Tiegelanordnung beim Kristallziehen in Rotation gehalten werden kann. Zur Erzeugung und Aufrechterhaltung der notwendigen Schmelzwärme sind die Tiegel 1, 3 mit einer Strahlungsheizung 8, z.B. einem mäanderförmigen Graphitheizelement umgeben. Die von diesem Heizelement 8 ausgehenden Wärmestrahlen werden vom Stütztiegel 3 aufgenommen und es wird die Wärme von diesem gleichmäßig an den Quarztiegel 1 und dessen Inhalt weitergegeben. Alle bis jetzt beschriebenen und einige nicht dargestellte Anlagenteile wie der drehbare, in die Siliciumschmelze eintauchende Kristallziehstab, Schutzgasführungseineinrichtungen, Abdeckungen oder Materialzuführungseinrichtungen befinden sich in einem nur auszugsweise wiedergegebenen geschlossenen Behälter mit einer mehrschalig aufgebauten, gut isolierenden Wand 9.

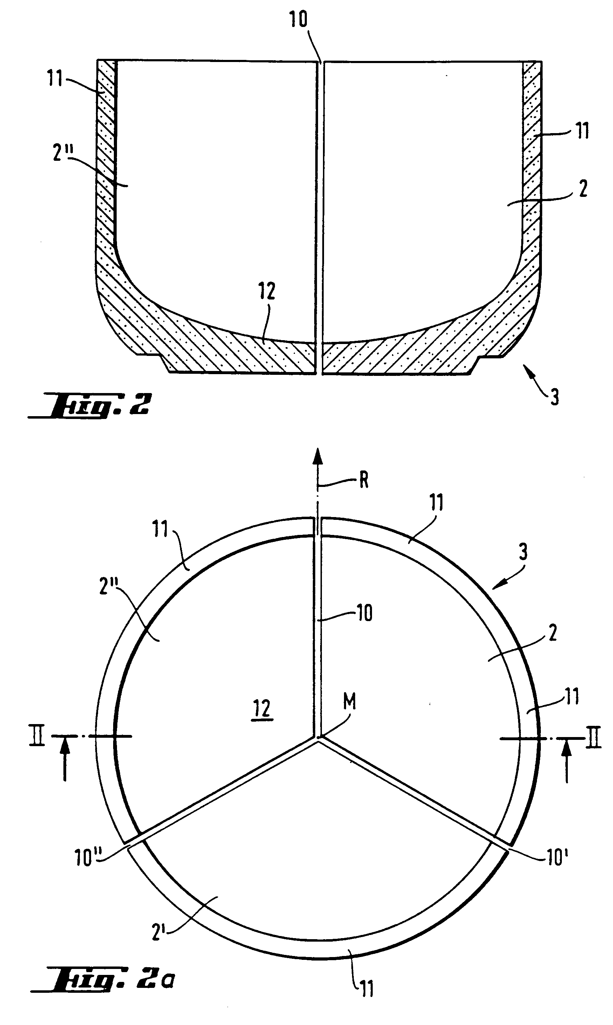

Fig. 2 und 2a zeigen einen aus drei Segmenten 2, 2', 2'' bestehenden Stütztiegel 3 nach dem Stand der Technik, bei dem die Wärmestrahlen durch die Fugen 10, 10', 10'' in der Tiegelwand 11 hindurchtreten können, da diese in Richtung der Radialen R liegen.

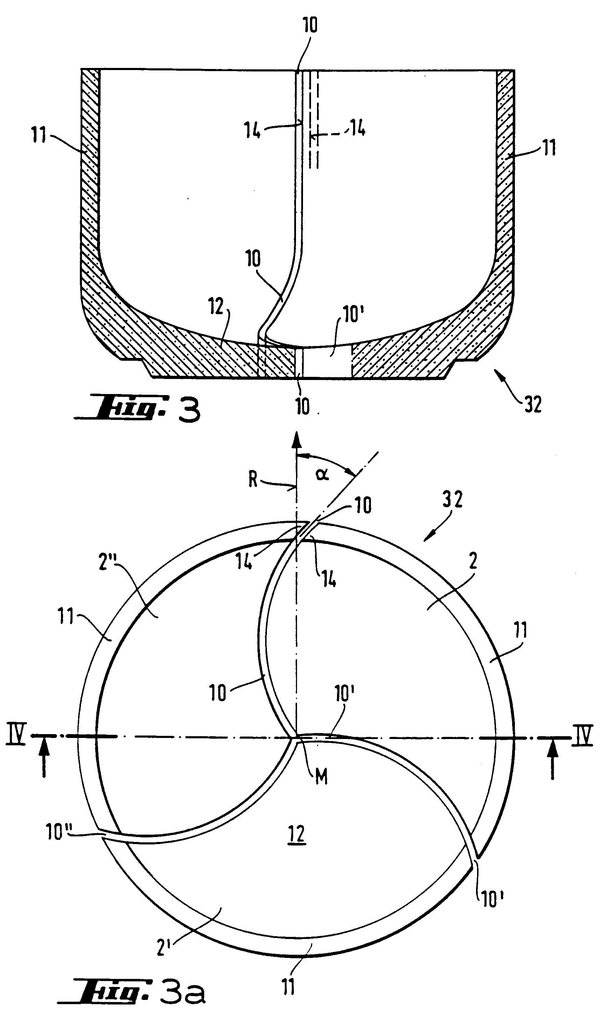

Eine erfindungsgemäße Ausführungsform eines aus drei Segmenten 2, 2', 2'' bestehenden Stütztiegels 32 ist in den Fig. 3 und 3a dargestellt. Die vertikal angeordneten, mit einer Krümmung versehenen Fugen 10, 10', 10'' durchsetzen hier die Tiegelwand 11 im zur Radialen R geneigten Winkel α. Sie sind durch einen an der Tiegelwand 11 ansetzenden und bogenförmig zur Mittelachse des Tiegels geführten Schnitt definiert. Der Tiegelboden 12 wird von den Fugen 10, 10', 10'' vertikal durchsetzt.

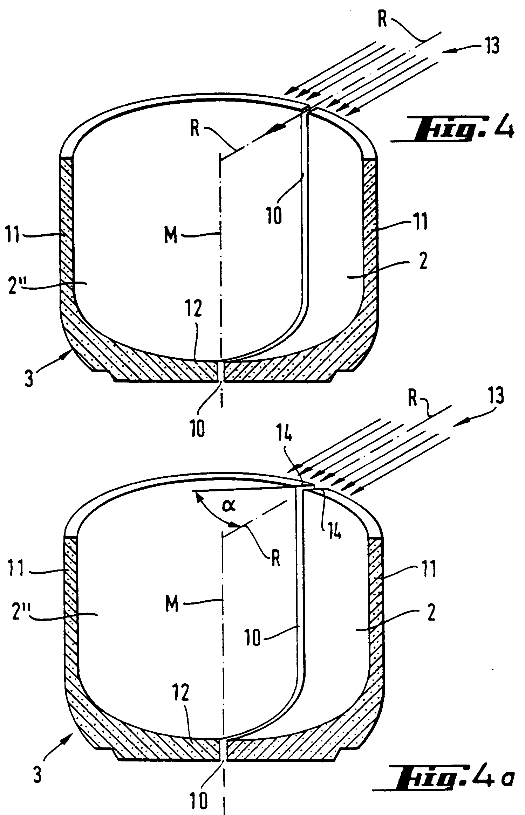

Durch die Figuren 4 und 4a wird die Wirkung der Erfindung veranschaulicht. In Fig. 4 gehen die radial auf die Tiegelwand 11 auftreffenden Wärmestrahlen 13 durch die die Segmente 2, 2' trennende Fuge 10 hindurch. Sie können auf den nicht dargestellten Quarztiegel treffen. In Fig. 4a werden die Wärmestrahlen durch die Überlappungszone 14 der Segmente 2, am Durchtritt durch die Fugen 10 gehindert. Ein innerhalb des Stütztiegels befindlicher, nicht dargestellter Quarztiegel kann von den vom nicht wiedergegebenen Heizelement kommenden, senkrecht auf die Tiegelwand fallenden Wärmestrahlen nicht mehr erreicht werden.

## Patentansprüche

1. Stütztiegel (3) aus mindestens zwei Segmenten (2, 2'), bei dem die Segmente (2) durch im Seitenwandbereich (11) des Tiegels (3) bis zum Tiegelboden (12) im wesentlichen senkrecht verlaufende und auch den Tiegelboden (12) durchsetzende Fugen (10) getrennt sind,
dadurch gekennzeichnet, daß
sich die, sich gegenüberliegenden, die Segmente (2) zum jeweiligen Nachbarsegment (2', 2'') begrenzenden Flächen im Betriebszustand in Umfangsrichtung des Tiegels (3) stets überlappen
und
daß diese Flächen mindestens im Seitenwandbereich (11) des Tiegels (3) eine der durch die Mittelachse und den größten Außenradius des Tiegels definierten Flächen schneiden.

2. Stütztiegel (3) gemäß dem Oberbegriff des Patentanspruchs 1
dadurch gekennzeichnet, daß
die sich gegenüberliegenden, die Segmente (2) zum jeweiligen Nachbarsegment begrenzenden Flächen komplementär geformt sind
und
daß diese Flächen durch an der Manteloberfläche des Tiegels (3) parallel zur Mittelachse des Tiegels im Winkel zur an diesem Ort durch die Mittelachse und den größten Außenradius des Tiegels (3) definierte Flächen ansetzende, bogenförmig zur Mittelachse des Tiegels (3) geführte Schnitte entstanden sind und daß sich diese Flächen im Betriebszustand in Umfangsrichtung des Tiegels (3) stets überlappen.

3. Stütztiegel (3) gemäß Patentanspruch 1,
dadurch gekennzeichnet, daß
die sich gegenüberliegenden, die Segmente (2) zum jeweiligen Nachbarsegment (2', 2'') begrenzenden Flächen komplementär geformt sind und sich im Betriebszustand in Umfangsrichtung des Tiegels (3) stets überlappen.

4. Stütztiegel (3) nach den Patentansprüchen 1, 2 und 3,
dadurch gekennzeichnet, daß
der Tiegel (3) aus drei Segmenten (2, 2', 2'') gleicher Gestalt besteht.

5. Stütztiegel (3) nach den Patentansprüchen 1, 2, 3 oder 4,
dadurch gekennzeichnet, daß
der Tiegel (3) aus Elektrographit besteht.

6. Stütztiegel (3) nach Patentanspruch 1, 2, 3 oder 4,
dadurch gekennzeichnet, daß
der Tiegel (3) aus kohlenstoffaserverstärktem Kohlenstoff besteht.

7. Stütztiegel (3) nach Patentanspruch 1, 2, 3 oder 4,
dadurch gekennzeichnet,
daß der Tiegel (3) aus glasartigem Kohlenstoff besteht.

8. Stütztiegel (3) nach einem oder mehreren der vorhergehenden Patentansprüche 1 bis 7,
dadurch gekennzeichnet, daß
der Tiegel (3) aus einem gasgereinigten Kohlenstoffwerkstoff besteht.

9. Verwendung von Stütztiegeln (3) mit einem oder mehreren der Kennzeichen der Patentansprüche 1 bis 8 für das Tiegelziehverfahren zur Herstellung von Kristallen.

10. Verfahren zur Herstellung eines Stütztiegels (3) aus mindestens zwei Segmenten (2, 2'), die durch im Seitenwandbereich des Tiegels (11) bis zum Tiegel boden (12) im wesentlichen senkrecht verlaufende und auch den Tiegelboden (12) durchsetzende Fugen (10, 10') getrennt sind,
dadurch gekennzeichnet, daß
die Tiegelsegmente (2, 2') durch Schnitte hergestellt werden, die an der Manteloberfläche (11) des noch nicht in Segmente (2, 2''') zerlegten Tiegels (3) parallel zur Mittelachse des Tiegels im Winkel zu einer Fläche ansetzen, die durch die Mittelachse des Tiegels (3) und den größten Außenradius des Tiegels am Ansatzort des Schnittes definiert ist und daß diese Schnitte bogenförmig vom Ansatzort am Tiegelmantel (11) ausgehend bis zur Mittelachse des Tiegels (3) ausgeführt werden.

## Claims

1. Supporting crucible (3) comprising at least two segments (2, 2'), with the segments (2) being separated by gaps (10) extending substantially vertically in the side-wall region (11) of the crucible (3) as far as the crucible base (12) and also passing through the crucible base (12), characterized in that the opposing surfaces which limit the segments (2) to the respective adjacent segment (2', 2'') always overlap in the operational state in the circumferential direction of the crucible (3) and in that these surfaces cut at least in the side-wall region (11) of the crucible (3) one of the surfaces defined by the centre axis and the largest outer radius of the crucible.

2. Supporting crucible (3) in accordance with the preamble of claim 1, characterized in that the opposing surfaces which limit the segments (2) to the respective adjacent segment are formed in a complementary manner and in that these surfaces have arisen through sections which are added to the generated surface of the crucible (3) parallel to the centre axis of the crucible at an angle to the surface defined at this point by the centre axis and the largest outer radius of the crucible (3) and which are guided in a curved manner to the centre axis of the crucible (3) and in that these surfaces in the operational state always overlap in the circumferential direction of the crucible (3).

3. Supporting crucible (3) according to claim 1, characterized in that the opposing surfaces which limit the segments (2) to the respective adjacent segment (2', 2'') are formed in a complementary manner and always overlap in the operational state in the circumferential direction of the crucible (3).

4. Supporting crucible (3) according to claims 1, 2 and 3, characterized in that the crucible (3) consists of three segments (2, 2', 2'') of the same form.

5. Supporting crucible (3) according to claims 1, 2, 3 or 4, characterized in that the crucible (3) consists of electrographite.

6. Supporting crucible (3) according to claim 1, 2, 3 or 4, characterized in that the crucible (3) consists of carbon-fibre-reinforced carbon.

7. Supporting crucible (3) according to claim 1, 2, 3 or 4, characterized in that the crucible (3) consists of vitreous carbon.

8. Supporting crucible (3) according to one or more of the above claims 1 to 7, characterized in that the crucible (3) consists of a gas-purified carbon material.

9. Use of supporting crucibles (3) having one or more of the characterizing features of claims 1 to 8 for the crucible-pulling method for producing crystals.

10. Method for producing a supporting crucible (3) from at least two segments (2, 2') which are separated by gaps (10, 10') extending substantially vertically in the side-wall region of the crucible (11) as far as the crucible base (12) and also passing through the crucible base (12), characterized in that the crucible segments (2, 2') are produced by means of sections which are added to the generated surface (11) of the crucible (3) and are not yet separated into segments (2, 2'''), the sections being added parallel to the centre axis of the crucible at an angle to a surface which is defined by the centre axis of the crucible (3) and the largest outer radius of the crucible at the attachment point of the section and in that these sections, as far as the centre axis of the crucible (3), are designed to extend arcuately from the attachment point at the crucible wall (11).

## Revendications

1. Creusets d'appui (3), comprenant au moins deux segments (2, 2') dans lequel les segments (2) sont séparés par des joints (10) s'étendant sur tout le domaine de paroi latérale (11) du creuset (3) jusqu'au fond du creuset (12), essentiellement verticalement entre eux en partageant aussi le fond (12), caractérisés en ce que les surfaces délimitant les segments (2) de chacun de ses voisins (2', 2'') et se faisant face se recouvrent toujours en état de marche dans le sens périphérique du creuset (3) et en ce que ces surfaces dans la zone de la paroi latérale (11) du creuset (3) coupent une des surfaces définie par l'axe médian et le plus grand rayon extérieur du creuset.

2. Creusets d'appui (3) selon le préambule de la revendication 1, caractérisés en ce que les surfaces limitrophes se faisant face délimitant chaque segment (2) par rapport au segment respectivement voisin sont de forme complémentaire et en ce que ces surfaces prennent naissance par des coupes dirigées en forme d'arc vers l'axe médian du creuset (3) appliquant des faces définies sur la surface enveloppe du creuset (3), parallèlement à l'axe médian du creuset et formant un angle par rapport à cet endroit par l'axe médian et le plus grand rayon extérieur du creuset (3) en ce que ces surfaces se recouvrent toujours en état de marche dans le sens périphérique du creuset (3).

3. Creusets d'appui (3) selon la revendication 1, caractérisés en ce que les surfaces se faisant face en délimitant les segments (2) vis-à-vis de chaque segment voisin (2', 2'') sont de forme complémentaire et en service se recouvrent toujours en périphérie du creuset (3).

4. Creusets d'appui (3) selon les revendications 1, 2 et 3, caractérisés en ce que le creuset (3) est constitué de trois segments (2, 2', 2'') de même forme.

5. Creusets d'appui (3) selon les revendications 1, 2, 3 ou 4, caractérisés en ce que le creuset (3) est en électrographite.

6. Creusets (3) selon les revendication 1, 2, 3 ou 4, caractérisés en ce que le creuset est en carbone renforcé de fibres de carbone.

7. Creusets d'appui (3) selon les revendications 1, 2, 3 ou 4, caractérisés en ce que le creuset (3) est en carbone vitreux.

8. Creusets d'appui (3) selon l'une ou plusieurs des revendications précédentes 1 à 7, caractérisés en ce que le creuset (3) est en carbone épuré au gaz.

9. Utilisation de creusets d'appui (3) selon l'une ou plusieurs des caractéristiques des revendications 1 à 8 pour le procédé de croissance destiné à produire des cristaux.

10. Procédé de production d'un creuset assemblé (3) comprenant au moins deux segments (2,2')qui sont séparés par des joints (10, 10'), s'étendent sur tout le domaine de paroi latérale (11) du creuset (3) jusqu'au fond du creuset (12), essentiellement verticalement et partagent aussi le fond (12), caractérisé en ce que les segments de creuset (2, 2') sont créés par des coupes qui s'aboutent à la surface enveloppe (11) du creuset (3) non encore fractionné en segment (2, 2''') parallèlement à l'axe médian du creuset en faisant un angle avec une surface qui est définie par l'axe médian du creuset (3) et le plus grand rayon extérieur du creuset au point d'épaulement de la coupe, et en ce en ce que ces faces sont incurvées depuis le point d'épaulement sur l'enveloppe du creuset (11) jusqu'à l'axe médian du creuset (3).
